# EUROPÄISCHE PATENTSCHRIFT

(11) **EP 1 248 508 B1**
(45) Veröffentlichungstag und Bekanntmachung des Hinweises auf die Patenterteilung: **06.08.2003**
(21) Anmeldenummer: 01108665.9
(22) Anmeldetag: 06.04.2001
(51) Int. Cl.: H05K 9/00, G01R 31/00

(54) **Verfahren, Anordnung und Sensor zum Prüfen der HF-Dichtigkeit eines Übergangs zwischen zwei aneinandergrenzenden Teilen**
Method, device and sensor for testing rf tightness of a junction between two adjacent parts
Procédé, dispositif et capteur d'essai de l'étanchéité HF d'une jonction entre deux pièces adjacentes

(43) Veröffentlichungstag der Anmeldung: 09.10.2002
(73) Patentinhaber: Schroff GmbH, D-75334 Straubenhardt (DE)
(72) Erfinder: Reiser, Peter, 76337 Waldbronn (DE); Benko, Robert, 75334 Straubenhardt-Conweiler (DE); Schwenk, Hans Martin, 75334 Straubenhardt (DE)
(74) Vertreter: Durm, Frank, Dipl.-Ing.

(56) Entgegenhaltungen:
- FR-A- 2 735 581
- US-A- 5 334 941
- US-A- 5 477 157
- US-A- 5 594 351
- LEE Y M: "A NEW APPARATUS FOR DETECTING FLAWS OF A SEAM IN A SHIELDED ENCLOSURE" PROCEEDINGS OF THE INTERNATIONAL SYMPOSIUM ON ELECTROMAGNETIC COMPATIBILITY. DALLAS, AUG. 9 - 13, 1993, NEW YORK, IEEE, US, 9. August 1993 (1993-08-09), Seiten 231-232, XP000427683
- KUNKEL G M: "INTRODUCTION TO THE TESTING FOR THE SHIELDING QUALITY OF EMI GASKETS AND GASKETED JOINTS" PROCEEDINGS OF THE INTERNATIONAL SYMPOSIUM ON ELECTROMAGNETIC COMPATIBILITY. ANAHEIM, AUG. 17 - 21, 1992, NEW YORK, IEEE, US, 17. August 1992 (1992-08-17), Seiten 134-138, XP000340107 ISBN: 0-7803-0714-3
- ECHIGO H ET AL: "PULSE LEAKAGE PHENOMENA DURING THE PROPAGATION ON THE INSIDE AND OUTSIDE OF A COAXIAL CABLE - AS A MODEL OF INTRA/INTER SYSTEM EMI-" IEICE TRANSACTIONS ON COMMUNICATIONS, INSTITUTE OF ELECTRONICS INFORMATION AND COMM. ENG. TOKYO, JP, Bd. E80-B, Nr. 11, 1. November 1997 (1997-11-01), Seiten 1625-1632, XP000733745 ISSN: 0916-8516

## Beschreibung

Die Erfindung betrifft ein Verfahren zum Prüfen der HF-Dichtigkeit eines Übergangs zwischen zwei aneinandergrenzenden, elektrisch leitfähigen Teilen, insbesondere Verkleidungsteilen eines HF-geschirmten Gehäuses für den Einbau von elektronischen Geräten.

Elektronische Geräte sind empfindlich gegen Störungen, die durch hochfrequente elektromagnetische Wechselfelder hervorgerufen werden. Elektronische Geräte strahlen aber oft auch selbst elektromagnetische Wellen ab. Um die elektromagnetische Verträglichkeit (EMV) zu gewährleisten, müssen deshalb Gehäuse für den Einbau von elektronischen Geräten gegen Einstrahlung und Abstrahlung elektromagnetischer Wellen geschirmt sein.

Die Dichtigkeit eines Gehäuses gegenüber hochfrequenten elektromagnetischen Schwingungen beruht auf der Schirmwirkung der metallenen Wände. Hierfür sind im wesentlichen zwei physikalische Effekte verantwortlich: Zum einen induzieren die einfallenden Wellen hochfrequente Ströme in den Teilen, welche entgegengesetzt gerichtete elektromagnetische Wellen erzeugen. Hierdurch wird die einfallende elektromagnetische Welle reflektiert. Zum anderen bewirkt der bei hohen Frequenzen auftretende Skin-Effekt, dass die durch die Hochfrequenz verursachten Ströme nur an der der ankommenden Welle zugewandten Oberfläche des Teils fließen. Die Eindringtiefe des HF-Stroms nimmt mit zunehmender Frequenz ab und bleibt bereits für relativ niedrige Frequenzen deutlich unterhalb der Dicke einer üblichen Gehäusewand. Dies führt dazu, dass die auf die Oberfläche treffende elektromagnetischen Wellen nicht durch die metallene Wand hindurch in das Innere des Gehäuses gelangt.

Problematisch hinsichtlich der HF-Dichtigkeit eines Gehäuses sind vor allem die Übergänge zwischen zwei aneinandergrenzenden Teilen aus Metall oder einem anderen, elektrisch leitfähigen Material, also beispielsweise zwischen Tür und Türrahmen oder zwischen Seitenwand und Rückwand. An einem solchen Übergang wird nämlich der Fluss der durch die HF induzierten Ströme unterbrochen, wodurch der Übergang für hochfrequente magnetische Wellen durchlässig wird. Bei HF-geschirmten Gehäusen werden deshalb die Übergänge zwischen zwei aneinandergrenzenden Teilen mit Hilfe von speziellen, elektrisch gut leitfähigen HF-Dichtungen gegen das Eindringen oder Austreten von HF-Strahlung abgedichtet. Speziell werden derartige HF-Dichtungen zwischen beweglichen Verkleidungsteilen, also beispielsweise zwischen Tür und Türrahmen eines Gehäuses, eingesetzt. Der Grad der HF-Dichtigkeit eines solchen Gehäuses mit durch nachträglich eingesetzten HF-Dichtungen abgedichteten Übergängen wird ganz wesentlich von der Qualität und dem einwandfreien Sitz der HF-Dichtung zwischen den zwei aneinandergrenzenden Verkleidungsteilen bestimmt.

Um nun zu prüfen, ob ein aus mehreren Teilen zusammengesetztes Gehäuse eine ausreichende HF-Dichtigkeit aufweist, sind zwei Methoden üblich.

Bei der Schirmdämpfungsmessung wird ein HF-Sender außerhalb des Gehäuses und eine Empfangsantenne innerhalb des Gehäuses angeordnet, oder umgekehrt. Es wird die Dämpfung gemessen, welche die Hochfrequenz durch das geschlossene Gehäuse erfährt. Ein großer Nachteil dieser Methode ist, dass immer nur die Gesamtdämpfung des ganzen Gehäuses gemessen wird; einzelne undichte Stellen können nicht detektiert werden. Ein weiterer Nachteil besteht darin, dass nur an einem leeren Gehäuse gemessen werden kann, und dass das Gehäuse für die Messung irreparabel beschädigt werden muss. Notwendigerweise muss nämlich entweder die Sendeantenne oder die Empfangsantenne im (leeren) Gehäuseinnenraum angeordnet werden und mit der übrigen Messapparatur durch mindestens eine Leitung, die durch eine Öffnung im Gehäuse führt, verbunden werden. Es ist also nicht möglich, ein bereits mit elektronischen Bauteilen bestücktes Gehäuse zu prüfen, beispielsweise darauf, ob Schirmkontakte oder HF-Dichtungen im Bereich der Türe beschädigt wurden oder das Gehäuse etwa nicht richtig aufgestellt ist, so dass einzelne HF-Dichtungen keinen Kontakt geben.

Bei der zweiten Methode, der Messung der HF-Dichtigkeit eines Gehäuses durch Strominjektion wird eine hochfrequente elektromagnetische Welle zwischen dem Gehäuse und einem Injektionsdraht erzeugt. Die abgestrahlte Hochfrequenz wird mit einem weiteren Draht oder einer Empfangsantenne, die im Innern des Gehäuses angeordnet sein muss, empfangen. Auch mit dieser Methode lassen sich nur leere Gehäuse prüfen. Nachteilig ist ferner, dass der Kabelschirm galvanisch mit dem Gehäuse verbunden sein muss, was notwendigerweise mit einer Beschädigung der in der Regel mit einer isolierenden Lackschicht versehenen Gehäuseoberfläche einhergeht.

Beiden genannten Prüfverfahren gemeinsam ist der Nachteil, dass das Meßergebnis durch Hohlraumresonanzen verfälscht wird, was zu einer schlechten Reproduzierbarkeit der Messungen führt. In der Praxis besonders störend ist aber, dass in jedem Fall der Prüfling irreparabel zerstört wird und es deshalb nicht möglich ist, die HF-Dichtigkeit eines mit elektronischen Geräten bestückten Gehäuses nachträglich, beispielsweise im Falle einer Reklamation, auf seine HF-Dichtigkeit zu überprüfen. Auch ist es mit den bekannten Methoden nicht möglich, einzelne HF-durchlässige Stellen aufzufinden.

Aus US 5 477 157 ist ein Prüfverfahren bekannt, bei dem die über einem Übergang eines metallischen Gehäuses abfallende Spannung gemessen wird. Dazu wird eine Signalquelle über einen koaxialen Leiter mit Innen- und Außenleiter mit einem Abschlusswiderstand verbunden. Der Außenleiter wird aufgetrennt und mit den beiden offenen Enden mit dem zu untersuchenden Gehäuse kontaktiert, so dass der Übergang des Gehäuses zwischen den beiden Enden liegt und ein Strom von der Signalquelle über den Übergang des Gehäuses fließt. Neben diesem Einspeisestromkreis ist ein zweiter getrennter Meßkreis vorgesehen, der aus einer Meßeinrichtung und zwei angeschlossenen Elektroden besteht. Je eine Elektrode kontaktiert das Gehäuse auf jeder Seite des Übergangs. Der Spannungsabfall über dem Übergang wird mit der Meßeinrichtung gemessen.

Der vorliegenden Erfindung liegt somit das technische Problem zugrunde, einen Übergang zwischen zwei aneinandergrenzenden Teilen, insbesondere zwischen zwei Wandteilen eines Gehäuses, selektiv auf HF-Dichtigkeit zu überprüfen, und zwar ohne jeden mechanischen Eingriff in die Struktur des Prüflings.

Die Lösung der gestellten Aufgabe beruht auf der Überlegung, dass für die Feststellung, ob ein Übergang zwischen zwei aneinandergrenzenden Teilen für hochfrequente elektromagnetische Schwingungen durchlässig ist oder nicht, eine Messung des Absolutwerts der Transmission und/oder Reflexion nicht unbedingt erforderlich ist, und dass es auch nicht notwendig ist, elektromagnetische Wellen durch die Teile hindurch zu senden, sei es nun von innen nach außen oder umgekehrt von außen nach innen.

Gelöst wird die Aufgabe zunächst durch das im Patentanspruch 1 angegebene Verfahren.

Erfindungsgemäß wird ein HF-Signal über den zu prüfenden Übergang hinweggeleitet und die Transmission und/oder Reflexion des Signals auf seinem Weg über den Übergang gemessen. Durch Vergleichen der gemessenen Transmission und/oder Reflexion mit einer durch die Geometrie des Übergangs vorgegebenen, charakteristischen Transmission und/oder Reflexion kann festgestellt werden, ob der Übergang die erforderliche HF-Dichtigkeit aufweist oder nicht. Für diese Feststellung reicht die Erkennung einer signifikanten Abweichung der gemessenen Werte für die Transmission bzw. Reflexion von den charakteristischen Werten aus; ein Absolutwert muss nicht gemessen werden.

Der große Vorteil des erfindungsgemäßen Verfahrens besteht darin, dass das HF-Signal die leitfähigen Teile nicht durchdringen muss. Hierdurch wird es erstmals möglich, ein mit elektronischen Geräten bestücktes Gehäuse in geschlossenem Zustand so, wie es normalerweise benutzt wird, auf HF-Dichtigkeit zu überprüfen. HF-Sender und HF-Messeinrichtung sind dabei beide außerhalb des Gehäuses angeordnet. Ein weiterer großer Vorteil des vorgeschlagenen Verfahrens ist, dass durch vergleichende Messung an verschiedenen Stellen eines Übergangs undichte Stellen lokalisiert werden können.

Bevorzugt besteht das HF-Signal aus einer Folge von elektromagnetischen Schwingungen unterschiedlicher Frequenz und wird der Verlauf der Transmission und/oder Reflexion in Abhängigkeit der Frequenz gemessen. Typischerweise besteht das HF-Signal aus durchgestimmten Sinussignalen. Alternativ kann aber auch ein Sprung- oder Impulssignal benutzt werden, da in einem solchen Signal ein breites Frequenzspektrum enthalten ist und die Analyse im Zeitbereich somit der Untersuchung im Frequenzbereich entspricht.

Aufgrund seiner Geometrie hat jeder Übergang einen charakteristischen Verlauf der Transmission und/oder Reflexion in Abhängigkeit der Frequenz des HF-Signals. Ein einwandfreier Übergang kann deshalb durch seinen charakteristischen Verlauf der Transmission und/oder Reflexion, vergleichbar einem Fingerabdruck, erkannt werden. Eine Abweichung des gemessenen Verlaufs der Transmission und/oder Reflexion von dem erwarteten charakteristischen Verlauf der Transmission und/oder Reflexion impliziert, dass der Übergang fehlerhaft und für HF durchlässig ist.

Ein für HF-geschirmte Gehäuse typisches Problem ist die stellenweise Undichtigkeit einer HF-Dichtung, beispielsweise zwischen Tür und Türrahmen. Um die undichte Stelle des Übergangs zu lokalisieren, werden mehrere Messungen durchgeführt, um zunächst einen charakteristischen Verlauf der Transmission und/oder Reflexion als Referenz zu erhalten. Dieser charakteristische Verlauf der Transmission und/oder Reflexion wird abgespeichert. Weicht nun der gemessene Verlauf der Transmission und oder Reflexion an einer bestimmten Stelle des Übergangs in augenfälliger Weise von dem abgespeicherten charakteristischen Verlauf der Transmission und/oder Reflexion ab, so muss die Ursache hierfür eine Undichtigkeit im Bereich des Übergangs sein. Mittels einer Reihe von Messungen an unterschiedlichen Stellen lässt sich der Bereich des Übergangs, der einwandfrei dicht ist, von den Stellen, die für HF durchlässig sind, eingrenzen.

In der Praxis bewährt hat sich die Verwendung eines Bildschirms, auf dem der gemessene Verlauf der Transmission und/oder Reflexion und der abgespeicherte charakteristische Verlauf der Transmission und/oder Reflexion gemeinsam zur Darstellung gebracht werden. Auf diese Weise lässt sich eine Abweichung vom charakteristischenVerlauf der Transmission und/oder Reflexion auf einen Blick feststellen. Die gemessenen Verläufe der Transmission und/oder Reflexion lassen sich aber auch numerisch auswerten, beispielsweise mittels eines Mikrorechners. Das Ergebnis wird dann als Gut/Schlecht-Anzeige ausgegeben, was sowohl optisch wie auch akustisch erfolgen kann.

In bevorzugter Weiterbildung des erfindungsgemäßen Verfahrens wird das HF-Signal auf der einen Seite des zu prüfenden Übergangs eingekoppelt und auf der gegenüberliegenden anderen Seite des Übergangs wieder ausgekoppelt, wobei die Einkoppelung und die Auskoppelung des HF-Signals in die leitfähigen Teile zweckmäßigerweise kapazitiv erfolgt. Damit wird es erstmals möglich, ohne Verletzung isolierender Schutzschichten, beispielsweise der Lackierung, und somit völlig zerstörungsfrei auch mit Elektronik gefüllte Gehäuse auf ihre HF-Dichtigkeit zu überprüfen.

Zur Durchführung des erfindungsgemäßen Verfahrens dient eine Anordnung gemäß Patentanspruch 7. Diese umfasst in an sich bekannter Weise einen HF-Generator, der ein HF-Messignal erzeugt. Wesentlicher Bestandteil der Prüfanordnung ist eine HF-Leitung, die das HF-Signal von dem HF-Generator über den zu prüfenden Übergang hinweg leitet, wodurch das HF-Signal teilweise gedämpft und/oder reflektiert wird. Diese Beeinflussung wird durch eine Messeinrichtung erfasst. Ein Analysator vergleicht die gemessenen Werte für die Transmission und/oder Reflexion mit vorgegebenen charakteristischen Werten. Eine signifikante Abweichung impliziert einen fehlerhaften Übergang.

Als HF-Generator wird vorzugsweise ein durchstimmbarer Frequenzgenerator eingesetzt. Das HF-Signal hat typischerweise einen Frequenzbereich, der ungefähr dem Frequenzbereich der abzuschirmenden HF-Strahlung entspricht, z. B. 30 MHz bis 1000 MHz.

Der Analysator enthält vorzugsweise einen Speicher zur Abspeicherung des charakteristischen Verlaufs der Transmission und/oder Reflexion, so dass ein Vergleich zwischen dem aktuell gemessenen Ist-Verlauf und dem erwarteten Soll-Verlauf erfolgen kann. Das Ergebnis dieses Vergleichs kann beispielsweise als Messkurven auf einem Bildschirm angezeigt werden. Alternativ lassen sich die Messergebnisse auch numerisch auswerten und das Ergebnis "Gut" bzw. "Schlecht" als Licht- oder Tonsignal ausgeben.

Um das HF-Signal über den zu prüfenden Übergang hinweg zu leiten, setzt man am besten Wellenleiter mit einem Innenleiter und einem Außenleiter ein. Ein erster Wellenleiter leitet das HF-Signal zu dem Übergang. Dort wird das HF-Signal in das eine der beiden aneinandergrenzenden Teile auf der einen Seite des Übergangs eingekoppelt. Hierzu ist eine erste Elektrode vorgesehen, welche mit dem Außenleiter des ersten Wellenleiters elektrisch leitend verbunden ist. Ein zweiter, gleich ausgebildeter Wellenleiter leitet das HF-Signal von dem Übergang weg zu der Messeinrichtung. Um das HF-Signal aus dem anderen Teil auf der gegenüberliegenden Seite des Übergangs wieder auszukoppeln, ist eine zweite Elektrode vorgesehen, welche mit dem Außenleiter des zweiten Wellenleiters elektrisch leitend verbunden ist. Die Innenleiter der beiden Wellenleiter sind mit einem Verbindungsleiter miteinander elektrisch leitend verbunden, wobei dieser Verbindungsleiter an dem Übergang vorbeigeführt ist.

Vorzugsweise wird ein Koaxialkabel eingesetzt, dessen Innenleiter an dem Übergang vorbeiführt, und dessen Außenleiter im Bereich des Übergangs unterbrochen ist. An die Stelle des fehlenden Außenleiters treten im Bereich des Übergangs die beiden Elektroden und die beiden aneinandergrenzenden, elektrisch leitfähigen Teile. Die elektromagnetischen Wellen werden zwischen den Oberflächen der aneinandergrenzenden Teile und dem Innenleiter des Koaxialkabels über den zu prüfenden Übergang hinweggeführt.

Zur Durchführung des erfindungsgemäßen Verfahrens wird im Rahmen der vorgeschlagenen Messanordnung ein Sensor gemäß Patentanspruch 13 benutzt. Der erfindungsgemäße Sensor umfasst einen ersten Wellenleiter und einen zweiten Wellenleiter sowie eine erste Elektrode zur Einkoppelung des HF-Signals auf der einen Seite des Übergangs und eine zweite Elektrode zur Auskoppelung des HF-Signals auf der anderen Seite des Übergangs.

Die Elektroden des Sensors sind vorzugsweise plattenförmig ausgebildet und können beispielsweise in einer Ebene liegen. Ein solcher Sensor ist besonders gut geeignet für die Prüfung von Übergängen zwischen zwei flachen, mit ihren Außenkanten aneinanderstoßenden Teilen.

Alternativ kann der Sensor auch mit recht winkelig zueinander angeordneten Elektroden ausgerüstet sein. Mit einem derart ausgebildeten Sensor lassen sich Übergänge in einer eckigen Konfiguration, also beispielsweise Fugen an den Ecken eines Gehäuses, überprüfen.

Schließlich können die Elektroden auch parallel und im Abstand zueinander angeordnet sein. Damit lassen sich Übergänge und HF-Dichtungen in Spalten gut prüfen.

In zweckmäßiger und vorteilhafter Weiterbildung hat der Sensor einen der Kontur des Gehäuses, an dem gemessen werden soll, angepassten Träger, wobei die Elektroden an der dem Gehäuse zugewandten Innenseite des Trägers vorgesehen sind. Diese Konstruktion gewährleistet, dass die Elektroden stets in einem definierten Abstand zueinander und zu dem zu prüfenden Übergang angeordnet sind, so dass eine Reihe von Vergleichsmessungen unter stets gleichbleibenden geometrischen Bedingungen stattfinden kann.

Weist der Sensor zudem einen mit dem Träger verbundenen Handgriff auf, so lässt er sich entlang eines Übergangs leicht verschieben, um an verschiedenen Stellen Messungen durchzuführen. Die beiden Wellenleiter können durch den Handgriff hindurchgeführt sein, so dass sie die Bewegung des Sensors von Hand nicht behindern.

In vorteilhafter Weiterbildung des erfindungsgemäßen Sensors ist in diesen ein HF-Generator und eine Messeinrichtung integriert, wobei der HF-Generator an den ersten Wellenleiter und die Messeinrichtung an den zweiten Wellenleiter angeschlossen sind. Auf diese Weise entsteht ein kompaktes handliches Prüfgerät, welches leicht transportiert und vor Ort eingesetzt werden kann. Zweckmäßigerweise enthält der Sensor auch gleich einen Analysator zur Auswertung der von der Messeinrichtung empfangenen Signale, wobei das Ergebnis der Prüfung optisch, beispielsweise durch eine Rot/Grün-Leuchtdiode, oder akustisch, beispielsweise durch einen Piezo-Schallwandler, ausgegeben werden kann.

Die Erfindung wird nachstehend anhand der beigefügten Zeichnungen näher erläutert. Es zeigen:
- Fig. 1: eine Anordnung zum Prüfen eines Übergangs zwischen zwei ebenen Teilen, in einem stark vereinfachten Prinzipbild;
- Fig. 2: ein elektrisches Ersatzschaltbild der Anordnung von Fig. 1;
- Fig. 3: zwei unterschiedliche Verläufe der Transmission im Vergleich;
- Fig. 4a bis 4d: vier verschiedene Sensoren zum Prüfen unterschiedlicher Übergänge, stark vereinfacht;
- Fig. 5a: einen Schrank mit einem Sensor zur Prüfung des Spaltes zwischen den Türen;
- Fig. 5b: den Sensor von Fig. 5a, in vergrößerter perspektivischer Darstellung;
- Fig. 6a: einen Schrank mit einem Sensor zur Prüfung der Fugen an einer Ecke;
- Fig. 6b: den Sensor von Fig. 6a in vergrößerter perspektivischer Darstellung.

In den Zeichnungen sind gleiche Elemente jeweils mit denselben Bezugszeichen versehen.

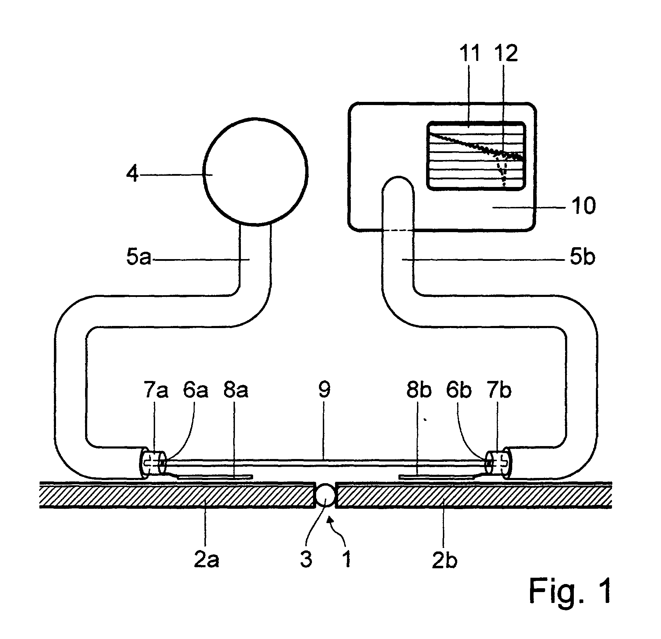

Die in Figur 1 schematisch dargestellte Anordnung dient zur Prüfung der HF-Dichtigkeit eines Übergangs 1 zwischen zwei aneinandergrenzenden flachen Teilen 2a und 2b eines Gehäuses für den Einbau elektronischer Geräte. Zwischen den beiden Teilen 2a und 2b ist eine HF-Dichtung 3 aus elektrisch gut leitendem Material eingesetzt. Die Teile 2a und 2b sind hier beispielhaft ebene Verkleidungsteile aus Metall. Ein HF-Generator erzeugt eine Folge von elektromagnetischen Sinus-Schwingungen zwischen 30 und 1000 MHz. Ein erster Wellenleiter 5a leitet das HF-Signal von dem HF-Generator 4 zu dem Übergang 1 hin. Der Wellenleiter 5a ist als Koaxialkabel ausgebildet und hat einen Innenleiter 6a und einen Außenleiter 7a, welche das HF-Signal führen.

Eine erste Elektrode 8a ist mit dem Außenleiter 7a des ersten Wellenleiters 5a elektrisch leitend verbunden. Die Elektrode 8a ist flach ausgebildet und liegt auf der Oberseite des Teils 2a auf. Auf diese Weise wird das von dem HF-Generator erzeugte HF-Signal in das erste der beiden aneinandergrenzenden Teile 2a auf der linken Seite des Übergangs 1 kapazitiv eingekoppelt.

Auf der anderen Seite des Übergangs 1 wird das HF-Signal aus dem zweiten Teil 2b wieder ausgekoppelt. Hierzu ist ein zweiter Wellenleiter 5b vorgesehen, der ebenfalls als Koaxialkabel ausgebildet ist und einen Innenleiter 6b und einen Außenleiter 7b aufweist. Der Außenleiter 7b des zweiten Wellenleiters 5b ist mit einer zweiten Elektrode 8b elektrisch leitend verbunden. Die zweite Elektrode 8b koppelt das HF-Signal aus dem zweiten Teil 2b auf der rechten Seite des Übergangs 1 kapazitiv aus.

Die Außenleiter 7a, 7b der Wellenleiter 5a, 5b sind bei dieser Anordnung einige Zentimeter vor bzw. hinter dem Übergang 1 unterbrochen. Die Innenleiter 6a, 6b sind jedoch durch einen Verbindungsleiter 9 elektrisch leitend miteinander verbunden, wobei der Verbindungsleiter 9 mit wenigen Millimetern Abstand über dem Übergang 1 vorbeigeführt ist.

Die beiden Wellenleiter 5a und 5b sind also zwei Abschnitte eines Koaxialkabels, dessen Außenleiter im Bereich des Übergangs 1 unterbrochen ist, während der Innenleiter durchverbunden bleibt. Der im Bereich des Übergangs fehlende Außenleiter wird ersetzt durch die flachen Elektroden 8a und 8b, die Oberseite der aneinandergrenzendenTeile 2a und 2b sowie die zwischenliegende HF-Dichtung 3.

Auf diese Weise wird das HF-Signal über den Übergang 1 hinweggeführt, wobei das HF-Signal aufgrund der an den Übergangsstellen auftretenden Reflexionen eine deutliche Änderung der Transmission erfährt. Das Maß der Transmission und/oder Reflexion ist abhängig von der Geometrie des Übergangs, insbesondere von der Leitfähigkeit und dem korrekten Sitz der HF-Dichtung 3 im Spalt zwischen den beiden Teilen 2a und 2b.

Der zweite Wellenleiter 5b leitet das aus dem rechten Teil 2b hinter dem Übergang 1 ausgekoppelte HF-Signal in eine Messeinrichtung 10. Die Messeinrichtung 10 ist mit einem Analysator verbunden, der eine numerische Auswertung der gemessenen Werte für die Transmission des HF-Signals vornimmt. Die Verläufe der Transmission in Abhängigkeit der Frequenz wird auf einem Bildschirm 11 zur Darstellung gebracht.

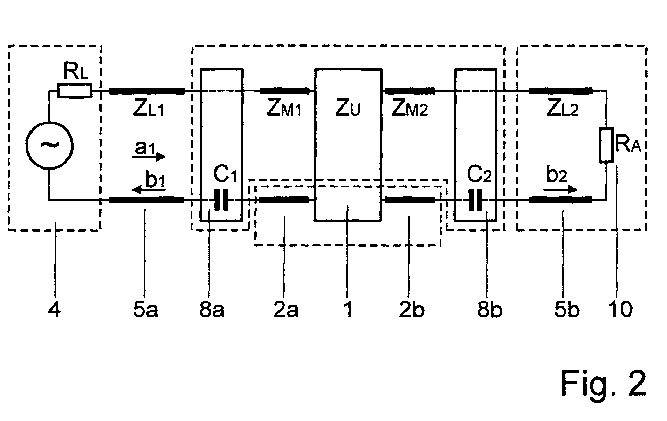

Das elektrische Ersatzschaltbild von Figur 2 erläutert das Messprinzip.

Die im HF-Generator 4 erzeugten HF-Signale a₁ werden durch den Wellenleiter 5a zu dem zu prüfenden Übergang 1 geleitet. Der Wellenleiter 5a hat einen bekannten Wellenwiderstand Z_{L1}. Das HF-Signal wird über die erste Elektrode 8a kapazitiv in das erste Teil 2a eingekoppelt. Dabei bildet die Elektrode 8a einen Hochpass mit der Kapazität C₁. Auf der gegenüberliegenden Seite des Übergangs 1 wird das HF-Signal aus dem anderen Teil 2b mittels der zweiten Elektrode 8b wieder kapazitiv ausgekoppelt. Die zweite Elektrode 8b bildet zusammen mit dem Teil 2b einen Hochpass mit der Kapazität C₂. Der das HF-Signal vom Übergang 1 ableitende Wellenleiter 5b bildet zusammen mit der angeschlossenen Messeinrichtung 10 einen Abschluss mit dem Wellenwiderstand Z_{L2} und dem Ohmschen Widerstand R_{A}.

Der aus der Verbindungsleitung 9 (vgl. Fig. 1), den aneinandergrenzenden Teilen 2a und 2b und dem dazwischenliegenden Übergang 1 mit der HF-Dichtung 3 gebildete Wellenleiter hat einen Wellenwiderstand, der sich zusammensetzt aus dem Wellenwiderstand Z_{M1} des ersten Teils 2a, dem Wellenwiderstand ZU des Übergangs 1 und dem Wellenwiderstand Z_{M2} des zweiten Teils 2b. Dabei sind die Wellenwiderstände Z_{M1} und Z_{M2} unabhängig vom Übergang 1. Der Wellenwiderstand ZU des Übergangs weicht von den Wellenwiderständen Z_{M1} und Z_{M2} ab, was zur teilweisen Reflexion des HF-Signals führt.

Der am Ende der Messtrecke transmittierte Teil b₂ des HF-Signals wird von der Messeinrichtung 10 empfangen. Die reflektierten Signalanteile b₁ sowie die transmittierten Signalanteile b₂ zeigen eine charakteristische Frequenzabhängigkeit, die von der Geometrie des Übergangs 1 abhängig ist. Ist der Übergang 1 fehlerhaft, d.h. für HF durchlässig, so ändert sich diese Frequenzabhängigkeit signifikant, wodurch die Detektion einer Störstelle möglich ist. Aufgetragen ist die Transmission T in Dezibel (dB) über der Frequenz in Hertz (Hz).

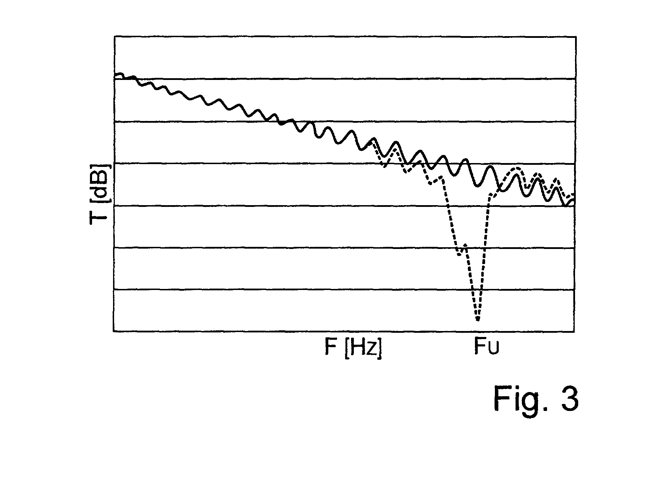

Figur 3 zeigt zwei Verläufe der transmittierten Anteile des HF-Signals für den Übergang 1. Die durchgezogene Linie ist der durch die Geometrie des Übergangs 1 vorgegebene charakteristische Verlauf der Transmission. Dieser zeigt einen Abfall zu höheren Frequenzen hin sowie kleinere Einbrüche bzw. Erhöhungen, die auf Resonanzen zurückzuführen sind. Die gestrichelte Linie ist ein typischer Ver-Iauf der Transmission, wie man ihn bei der Messung eines fehlerhaften Übergangs erhält. Deutlich ist der starke Einbruch des Signalpegels bei der Frequenz Fᵤ erkennbar.

Die Messanordnung muss auf die Geometrie des Übergangs abgestimmt sein. Je nachdem, ob die den Übergang 1 bildenden aneinandergrenzenden Teile 2a und 2b in einer Ebene liegen, eine Eckkonfiguration bilden oder parallel zueinander angeordnet sind, finden unterschiedlich ausgebildete Sensoren Verwendung.

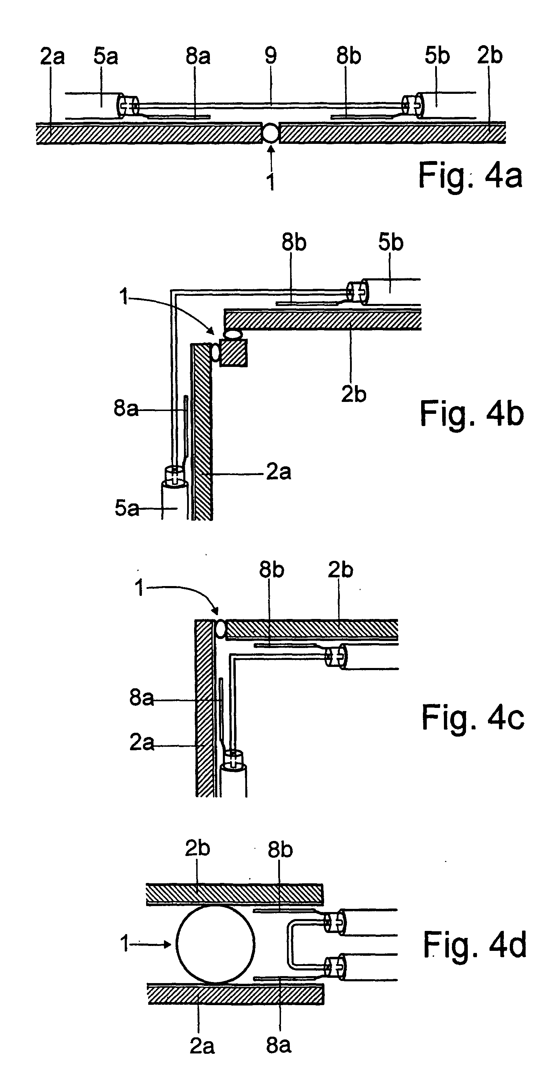

Figur 4a zeigt einen Flachsensor zur Überprüfung von Übergängen zwischen zwei aneinandergrenzenden, flachen Teilen 2a, 2b, die in einer gemeinsamen Ebene liegen. Die beiden Elektroden 8a und 8b sind plattenförmig ausgebildet, liegen ebenfalls in einer Ebene und weisen mit ihren Enden zueinander.

Oft müssen Übergänge zwischen zwei Teilen 2a, 2b geprüft werden, welche rechtwinklig zueinander angeordnet sind und eine Gehäuseecke bilden. Je nachdem, ob im Bereich dieser Ecke von außen oder von innen gemessen werden soll, findet entweder ein Ecksensor gemäß Fig. 4b oder ein Ecksensor gemäß Fig. 4c Anwendung. Hier sind die Elektroden 8a, 8b rechtwinklig zueinander geordnet.

Oftmals besteht der zu prüfende Übergang 1 auch aus einer Fuge zwischen zwei mit Abstand parallel zueinander angeordneten Teilen 2a, 2b, wie in Fig. 4d dargestellt. Ein derart ausgebildeter Übergang 1 kann am besten mit einem Schlitzsensor geprüft werden, bei dem die Elektroden 8a und 8b parallel und im Abstand zueinander angeordnet sind.

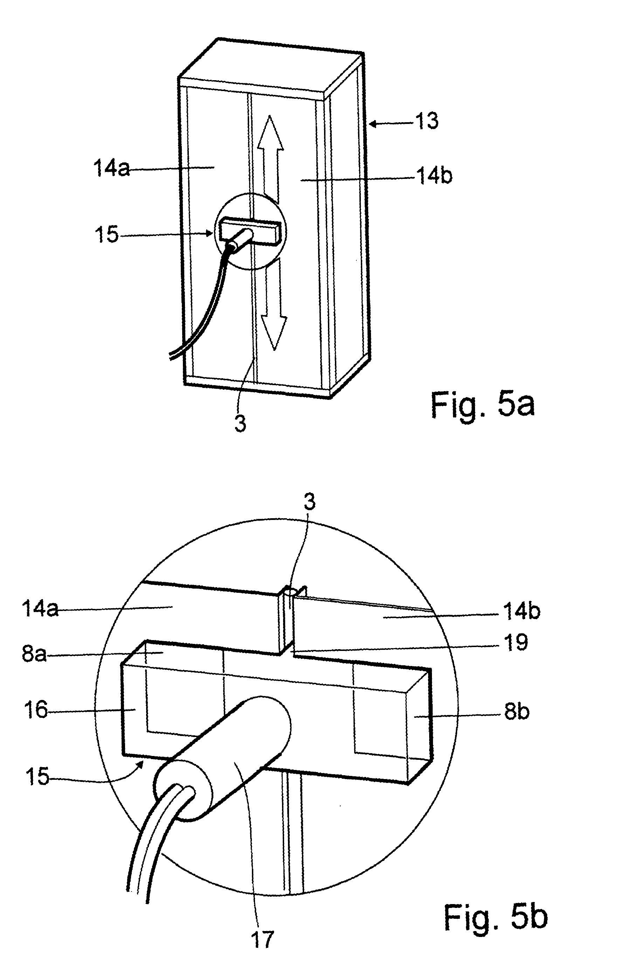

Figur 5a verdeutlicht, wie die HF-Dichtigkeit eines Gehäuses 13 für elektronische Geräte im geschlossenen Zustand von außen geprüft werden kann. Das Gehäuse 13 hat zwei Türen 14a und 14b, welche den Teilen 2a und 2b der Messanordnung von Fig. 1 entsprechen. Der Spalt zwischen den beiden Türen 14a und 14b bildet den Übergang 1, dessen HF-Dichtigkeit zu prüfen ist. Hierzu dient ein Flachsensor 15.

Gemäß Figur 5b hat der Flachsensor 15 ein der Kontur des Gehäuses 13 angepassten Träger 16, an dessen dem Gehäuse 13 zugewandten, im Wesentlichen ebenen Innenseite die beiden plattenförmigen Elektroden 8a und 8b angeordnet sind. Der Flachsensor 15 weist ferner einen mit dem Träger 16 verbundenen Handgriff 17 auf, durch den zwei Koaxialkabel 18a und 18b hindurchgeführt sind. An der dem Handgriff 17 gegenüberliegenden Seite des Trägers 16 ist ein Führungssteg 19 vorgesehen, der in den Spalt zwischen den beiden Türen 14a und 14b eingreift.

Durch Verschieben des Flachsensors 15 nach oben und unten, wie in Figur 5a durch zwei Pfeile angedeutet, lässt sich nun der Verlauf der Transmission und/oder Reflexion des HF-Signals für diesen Übergang 1 zwischen den Türen 14a, 14b an verschiedenen Stellen messen. Durch Vergleich der erhaltenen Verläufe der Transmission und/oder Reflexion kann festgestellt werden, ob der Spalt zwischen den Türen 14a und 14b auf seiner gesamten Länge HF-dicht ist oder an einer bestimmten Stelle eine Undichtigkeit vorliegt.

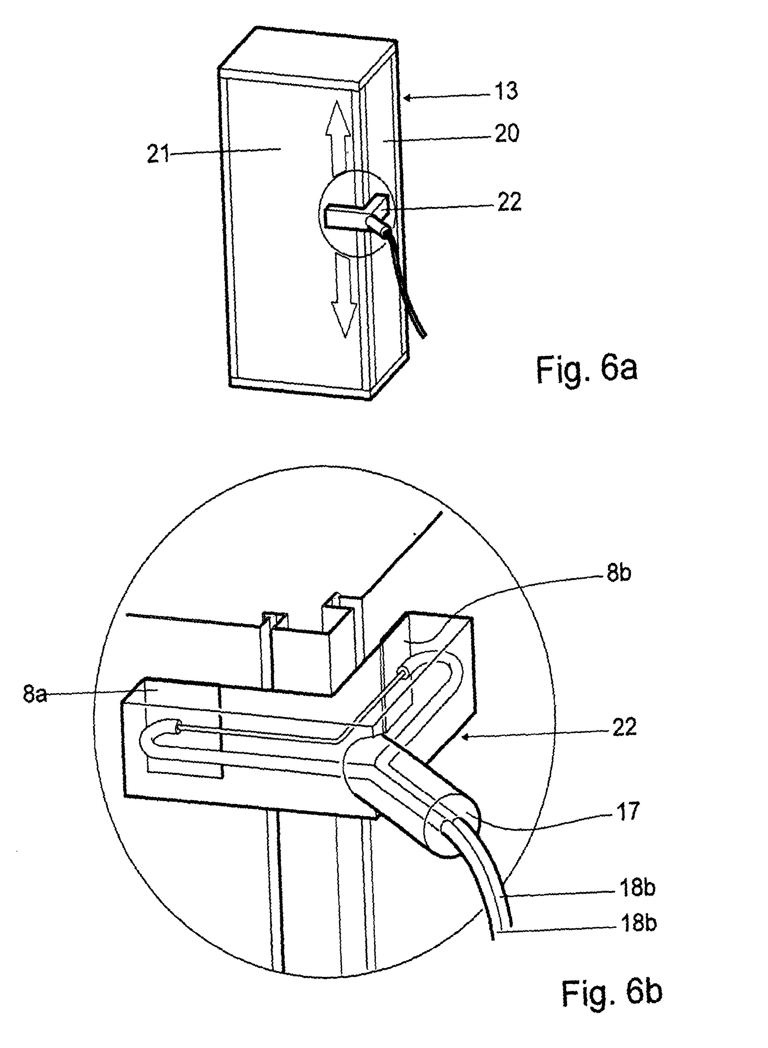

In Figur 6a ist die Rückseite des Gehäuses 13 zu sehen. Zum Prüfen der Dichtigkeit des Übergangs 1 zwischen Seitenteil 20 und Rückwand 21 dient ein Ecksensor 22, dessen Elektroden 8a und 8b rechtwinklig zueinander angeordnet sind. Die durch den Handgriff 17 hindurchgeführten Koaxialkabel 18a, 18b dienen der Zuführung bzw. Ableitung eines HF-Signals zu und von den Elektroden 8a, 8b.

### Zusammenstellung der Bezugszeichen

- 1: Übergang
- 2a, 2b: Teile
- 3: HF-Dichtung
- 4: HF-Generator
- 5a, 5b: Wellenleiter
- 6a, 6b: Innenleiter
- 7a, 7b: Außenleiter
- 8a, 8b: Elektroden
- 9: Verbindungsleiter
- 10: Messeinrichtung
- 11: Bildschirm
- 12: Messkurve
- 13: Gehäuse
- 14a, 14b: Türen (von 13)
- 15: Flachsensor
- 16: Träger
- 17: Handgriff
- 18a, 18b: Koaxialkabel
- 19: Führungssteg
- 20: Seitenteil (von 13)
- 21: Rückwand (von 13)
- 22: Ecksensor

## Patentansprüche

1. Verfahren zum Prüfen der HF-Dichtigkeit eines Übergangs zwischen zwei andeinandergrenzenden, elektrisch leitfähigen Teilen, insbesondere Verkleidungsteilen eines HF-geschirmten Gehäuses für den Einbau von elektronischen Geräten, mit den Schritten:
- Erzeugen eines HF-Signals von hochfrequenten elektromagnetischen Schwingungen;
- Leiten des HF-Signals über den zu prüfenden Übergang (1) hinweg;
**gekennzeichnet durch** die Schritte:
- Messen eines Signalanteils des HF-Signals auf seinem Weg über den Übergang (1), wobei der Signalanteil die Transmission und/oder Reflexion ist;
- Vergleichen des gemessenen Signalanteils mit einem vorgegebenen, für den Übergang (1) charakteristischen Signalanteil.

2. Verfahren nach Anspruch 1, **dadurch gekennzeichnet, dass**
- das HF-Signal aus einer Folge von elektromagnetischen Schwingungen unterschiedlicher Frequenz besteht;
- der Verlauf des Signalanteils in Abhängigkeit der Frequenz gemessen wird.

3. Verfahren nach Anspruch 2, **dadurch gekennzeichnet, dass** der gemessene Verlauf des Signalanteils mit einem zuvor abgespeicherten charakteristischen Verlauf des Signalanteils verglichen wird.

4. Verfahren nach Anspruch 3, **dadurch gekennzeichnet, dass** der gemessene Verlauf des Signalanteils und der abgespeicherte charakteristische Verlauf des Signalanteils gemeinsam auf einem Bildschirm zur Darstellung gebracht werden.

5. Verfahren nach einem der Ansprüche 1 bis 4, **dadurch gekennzeichnet, dass**
- das HF-Signal in das eine der beiden aneinandergrenzenden Teile (2a) auf der einen Seite des Übergangs (1) eingekoppelt wird;
- das HF-Signal aus dem anderen Teil (2b) auf der anderen Seite des Übergangs (1) wieder ausgekoppelt wird.

6. Verfahren nach Anspruch 5, **dadurch gekennzeichnet, dass** die Einkoppelung und die Auskoppelung des HF-Signals kapazitiv erfolgt.

7. Anordnung zum Prüfen der HF-Dichtigkeit eines Übergangs zwischen zwei aneinandergrenzenden, elektrisch leitfähigen Teilen, insbesondere Verkleidungsteilen eines HF-geschirmten Gehäuses für den Einbau von elektronischen Geräten, mit
- einem HF-Generator (4), der ein HF-Signal von hochfrequenten elektromagnetischen Schwingungen erzeugt;
- einer HF-Leitung, die das HF-Signal von dem HF-Generator (4) über den zu prüfenden Übergang (1) hinweg leitet;
und **gekennzeichnet durch**
- eine Messeinrichtung (10), welche einen Signalanteil des HF-Signals auf seinem Weg über den Übergang (1) misst, wobei der Signalanteil die Transmission und/oder Reflexion ist, und
- einen Analysator, der den gemessenen Signalanteil mit einem vorgegebenen, für den Übergang (1) charakteristischen Signalanteil vergleicht.

8. Anordnung nach Anspruch 7, **dadurch gekennzeichnet, dass**
- der HF-Generator (4) eine Folge von elektromagnetischen Schwingungen unterschiedlicher Frequenz erzeugt;
- die Messeinrichtung (10) den Verlauf des Signalanteils in Abhängigkeit der Frequenz misst.

9. Anordnung nach Anspruch 8, **dadurch gekennzeichnet, dass** der Analysator den gemessenen Verlauf des Signalanteils mit einem zuvor abgespeicherten charakteristischen Verlauf des Signalanteils vergleicht.

10. Anordnung nach Anspruch 9, **dadurch gekennzeichnet, dass** der Analysator einen Bildschirm (11) umfasst, auf dem der gemessene Verlauf des Signalanteils und der abgespeicherte charakteristische Verlauf des Signalanteils gemeinsam zur Darstellung gebracht werden.

11. Anordnung nach einem der Ansprüche 7 bis 10, **dadurch gekennzeichnet, dass** die HF-Leitung
- einen ersten Wellenleiter (5a), der das HF-Signal zwischen einem Innenleiter (6a) und einem Außenleiter (7a) von dem HF-Generator (4) zu dem Übergang (1) leitet,
- eine erste Elektrode (8a), die das HF-Signal in das eine der beiden aneinandergrenzenden Teile (2a) auf der einen Seite des Übergangs (1) einkoppelt und mit dem Außenleiter (7a) des ersten Wellenleiters (5a) elektrisch leitend verbunden ist,
- einen zweiten Wellenleiter (5b), der das HF-Signal zwischen einem Innenleiter (6a) und einem Außenleiter (7b) von dem Übergang (1) weg zu der Messeinrichtung (10) leitet,
- eine zweite Elektrode (8b), die das HF-Signal aus dem anderen Teil (2b) auf der gegenüberliegenden Seite des Übergangs (1) auskoppelt und mit dem Außenleiter (7b) des zweiten Wellenleiters (5b) elektrisch leitend verbunden ist,
- einen Verbindungsleiter (9), der den Innenleiter (6a) des ersten Wellenleiters (5a) mit dem Innenleiter (6b) des zweiten Wellenleiters (5a) elektrisch leitend verbindet, wobei der Verbindungsleiter (9) an dem Übergang vorbei führt,
aufweist.

12. Anordnung nach Anspruch 11, **dadurch gekennzeichnet, dass** die HF-Leitung ein Koaxialkabel ist, dessen Innenleiter als Verbindungsleiter (9) an dem Übergang (1) vorbeigeführt wird und dessen Außenleiter (7a, 7b) im Bereich des Übergangs (1) unterbrochen ist.

13. Anordnung nach einem der Ansprüche 7 bis 10, wobei die HF-Leitung einen Sensor zum Prüfen der HF-Dichtigkeit eines Übergangs zwischen zwei aneinandergrenzenden, elektrisch leitfähigen Teilen, insbesondere Verkleidungsteilen eines HF-geschirmten Gehäuses für den Einbau von elektronischen Geräten, mit
- einem ersten Wellenleiter (5a), der ein HF-Signal zwischen einem Innenleiter (6a) und einem Außenleiter (7b) führt,
- einer ersten Elektrode (8a), die mit dem Außenleiter (7a) des ersten Wellenleiters (5a) elektrisch leitend verbunden ist und zur Einkoppelung des HF-Signals in das eine der beiden aneinandergrenzenden Teile (2a) auf der einen Seite des Übergangs (1) dient,
- einem zweiten Wellenleiter (5b) mit einem Innenleiter (6b) und einem Außenleiter (7b) zum Anschluss einer Messeinrichtung (10),
- einer zweiten Elektrode (8b), die mit dem Außenleiter (7b) des zweiten Wellen leiters (5b) elektrisch leitend verbunden ist und der Auskoppelung des HF-Signals aus dem anderen Teil (2b) auf der anderen Seite des Übergangs (1) dient, und
- einem Verbindungsleiter (9), der den Innenleiter (6a) des ersten Wellenleiters (5a) mit dem Innenleiter (6b) des zweiten Wellenleiters (5b) elektrisch leitend verbindet,
aufweist.

14. Anordnung nach Anspruch 13, **dadurch gekennzeichnet, dass** der erste Wellenleiter (5a) und der zweite Wellenleiter (5b) als Abschnitte eines Koaxialkabels ausgebildet sind, dessen Außenleiter (7a, 7b) im Bereich zwischen den beiden Elektroden (8a, 8b) unterbrochen ist und dessen Innenleiter (6a, 6b, 9) durchverbunden ist.

15. Anordnung nach Anspruch 13 oder 14, **dadurch gekennzeichnet, dass** die beiden Elektroden (8a, 8b) plattenförmig ausgebildet sind.

16. Anordnung nach Anspruch 15, **dadurch gekennzeichnet , dass** die Elektroden (8a, 8b) in einer Ebene liegen und mit ihren Enden zueinander weisen.

17. Anordnung nach Anspruch 15, **dadurch gekennzeichnet, dass** die Elektroden (8a, 8b) rechtwinklig zueinander angeordnet sind.

18. Anordnung nach Anspruch 15, **dadurch gekennzeichnet , dass** die Elektroden (8a, 8b) parallel und im Abstand zueinander angeordnet sind.

19. Anordnung nach einem der Ansprüche 13 bis 18, **gekennzeichnet durch** einen der Kontur des Gehäuses (13) angepassten Träger (16), an dessen dem Gehäuse (13) zugewandten Innenseite die beiden Elektroden (8a, 8b) angeordnet sind.

20. Anordnung nach Anspruch 19, **gekennzeichnet durch** einen mit dem Träger (16) verbundenen Handgriff (17), **durch** den die beiden Wellenleiter (5a, 5b; 18a, 18b) hindurch geführt sind.

21. Anordnung nach einem der Ansprüche 13 bis 19, **dadurch gekennzeichnet, dass**
- an den ersten Wellenleiter (5a) der HF-Generator (4) angeschlossen ist;
- an den zweiten Wellenleiter (5b) die Messeinreichtung (10) angeschlossen ist; und
- der HF-Generator (4) und die Messeinrichtung (10) in den Sensor integriert sind.

22. Anordnung nach Anpruch 21, **dadurch gekennzeichnet, dass** der Sensor den Analysator zur Auswertung des von der Messeinrichtung (10) empfangenen Signalanteils enthält.

## Claims

1. A process for testing the RF-tightness of a seam between two mutually adjacent, electrically conducting parts, particularly enclosure parts of an RF-screened housing for the installation of electronic devices, with the steps of:
- producing an RF signal of high frequency electromagnetic oscillations;
- conducting away the RF signal through the seam (1) to be tested;
- **characterised by** the steps of:
- measuring a portion of the signal of the RF signal on its way through the seam (1), whereby the signal portion is the transmission and/or reflection;
- comparing the measured signal portion with a predetermined signal portion characteristic for the seam (1).

2. A process according to claim 1 **characterised in that**
- the RF signal consists of a series of electromagnetic oscillations of different frequencies;
- the characteristic curves of the signal portions are measured as a function of the frequency.

3. A process according to claim 2 **characterised in that** the measured characteristic curves of the signal portion are compared with a previously stored characteristic curve of the signal portion.

4. A process according to claim 3 **characterised in that** the measured characteristic curve of the signal portion and the stored characteristic curve of the signal portion are brought together on a monitor screen for illustration.

5. A process according to one of claims 1 to 4 **characterised in that**
- the RF signal is coupled to one of the two mutually adjacent parts (2a) of one side of the seam (1);
- the RF signal is again de-coupled from the other part (2b) on the other side of the seam (1).

6. A process according to claim 5 **characterised in that** the coupling in and de-coupling of the RF signal takes place capacitatively.

7. Apparatus for testing the RF-tightness of a seam between two mutually adjacent, electrically conductive parts, particularly enclosure parts of an RF-shielded enclosure for the installation of electronic devices, with
- an RF generator (4) that produces an RF signal of high frequency electromagnetic oscillations;
- an RF conductor that conducts the RF signal from the RF generator (4) over the seam (1) to be tested; and **characterised by**:
- a measuring apparatus (10) which measures a signal portion of the RF signal on its way through the seam (1), wherein the signal portion is transmission and/or reflection; and
- an analyser which compares the measured signal portion with a predetermined signal portion characteristic for the seam (1).

8. Apparatus according to claim 7 **characterised in that**
- the RF generator (4) produces a sequence of electromagnetic oscillations of differing frequencies;
- the measuring apparatus (10) measures the characteristic curve of the signal portion in dependence on the frequency.

9. Apparatus according to claim 8 **characterised in that** the analyser compares the measured characteristic curve of the signal portion with a previously stored characteristic curve of the signal portion.

10. Apparatus according to claim 9 **characterised in that** the analyser includes a monitor screen (11) on which the measured characteristic curve of the signal portion and the stored characteristic curve of the signal portion are brought together for display.

11. Apparatus according to one of claims 7 to 10 **characterised in that** the RF conductor has
- a first waveguide (5a) which conveys the RF signal between an inner conductor (6a) and the outer conductor (7a) of an RF generator (4) to the seam (1);
- a first electrode (8a) which feeds the RF signal into one of the two mutually adjacent parts (2a) on one side of the seam (1) and is electrically conductively connected with the outer conductor (7a) of the first waveguide (5a);
- a second waveguide (5b) which conveys the RF signal between an inner conductor (6a) and the outer conductor (7b) away from the seam (1) to the measuring apparatus (10);
- a second electrode (8b) which de-couples the RF signal from the other part (2b) of the oppositely lying side of the seam (1) and is electrically conductively connected with the outer conductor (7b) of the second waveguide (5b);
- a connecting lead (9) which electrically connects the inner conductor (6a) of the first waveguide (5a) with the inner conductor (6b) of the second waveguide (5b), wherein the connecting lead (9) leads past the seam.

12. Apparatus according to claim 11 **characterised in that** the RF conductor is a coaxial cable the inner conductor of which is guided past the seam (1) as a connecting lead (9) and the outer conductor (7a, 7b) of which is interrupted in the region of the seam (1).

13. Apparatus according to one of claims 7 to 10 wherein the RF lead has a sensor for testing the RF-tightness of seam between two mutually adjacent, electrically conductive parts, in particular enclosure parts of an RF-shielded housing for the installation of electronic components, with
- a first waveguide (5a) that guides the RF signal between an inner conductor (6a) and an outer conductor (7b);
- a first electrode (8a) which is electrically conductively connected with the outer conductor (7a) of the first waveguide (5a) and serves for the coupling of the RF signal to one of the two mutually adjacent parts (2a) on one side of the seam (1);
- a second waveguide (5b) with an inner conductor (6b) and an outer conductor (7b) for connection to a measuring device (10);
- a second electrode (8b) which is electrically conductively connected with the outer conductor (7b) of the second waveguide (5b) and serves for the de-coupling of the RF signal from the other part (2b) on the other side of the seam (1); and
- a connection lead (9) which electrically conductively connects the inner conductor (6a) of the first waveguide (5a) with the inner conductor (6b) of the second waveguide (5b).

14. Apparatus according to claim 13 **characterised in that** the first waveguide (5a) and the second waveguide (5b) are formed of sections of a coaxial cable the outer conductors (7a, 7b) of which are interrupted in the region between the two electrodes (8a, 8b) and whose inner conductor (6a, 6b, 9) is connected through.

15. Apparatus according to claims 13 or 14 **characterised in that** both electrodes (8a, 8b) are formed as plates.

16. Apparatus according to 15 **characterised in that** both electrodes (8a, 8b) lie in one plane and their ends are directed towards each other.

17. Apparatus according to claim 15 **characterised in that** the electrodes (8a, 8b) are arranged perpendicularly to each other.

18. Apparatus according to claim 15 **characterised in that** the electrodes (8a, 8b) are arranged in parallel and in a spaced relationship to each other.

19. Apparatus according to one claims 13 to 18 **characterised by** a carrier (16) matched to the contour of the enclosure (13), the two electrodes (8a, 8b) being arranged on the inner side of the carrier facing the enclosure (13).

20. Apparatus according to claim 19 **characterised by** a hand grip (17) which is connected with the carrier (16) and through which the two waveguides (5a, 5b; 18a, 18b) are passed.

21. Apparatus to one of claims 13 to 19 **characterised in that**
- the RF generator (4) is connected to the first waveguide (5a);
- the measuring device (10) is connected to the second waveguide (5b); and
- the RF generator (4) and the measuring apparatus (10) are integrated in the sensor.

22. Apparatus according to claim 21 **characterised in that** the sensor contains the analyser for evaluating the signal portion received by the measuring device (10).

## Revendications

1. Procédé pur le contrôle de l'étancheité HF d'une jonction entre deux pièces adjacentes électriquement conductrices, en particulier des parties de revêtement d'un boîtier blindé HF pour le montage d'appareils électroniques, comprenant les phases suivantes :
- génération d'un signal HF d'oscillations électromagnétiques à haute fréquence ;
- acheminement du signal HF par-delà la jonction (1) à contrôler ;
**caractérisé par** les phases suivantes :
- mesure d'une fraction de signal du signal HF sur son parcours à travers la jonction (1), la fraction de signal étant la transmission et/ou la réflexion ;
- comparaison de la fraction de signal mesurée à une fraction de signal prédéfinie, caractéristique de la jonction (1).

2. Procédé suivant la revendication 1, **caractérisé en ce que**
- le signal HF se compose d'une suite d'oscillations électromagnétiques de fréquence différente ;
- la courbe de la fraction de signal est mesurée en fonction de la fréquence.

3. Procédé suivant la revendication 2, **caractérisé en ce que** la courbe mesurée de la fraction de signal est comparée à une courbe caractéristique préalablement mémorisée de la fraction de signal.

4. Procédé suivant la revendication 3, **caractérisé en ce que** la courbe mesurée de la fraction de signal et la courbe caractéristique mémorisée de la fraction de signal sont affichées conjointement sur un écran.

5. Procédé suivant l'une des revendications 1 à 4, **caractérisé en ce que**
- le signal HF est couplé dans l'une (2a) des deux pièces adjacentes sur l'un des côtés de la jonction (1) ;
- le signal HF est découplé de l'autre pièce (2b) sur l'autre côté de la jonction (1).

6. Procédé suivant la revendication 5, **caractérisé en ce que** le couplage et le découplage du signal HF sont capacitifs.

7. Dispositif pour le contrôle de l'étanchéité HF d'une jonction entre deux pièces adjacentes électriquement conductrices, en particulier des parties de revêtement d'un boîtier blindé HF pour le montage d'appareils électroniques, comprenant :
- un générateur HF (4), qui génère un signal HF d'oscillations électromagnétiques à haute fréquence ;
- une ligne HF, qui achemine le signal HF du générateur HF (4) par-delà la jonction (1) à contrôler ;
et **caractérisé par**
- un dispositif de mesure (10), qui mesure une fraction de signal du signal HF sur son parcours à travers la jonction (1), la fraction de signal étant la transmission et/ou la réflexion ; et
- un analyseur, qui compare la fraction de signal mesurée à une fraction de signal prédéfinie, caractéristique de la jonction (1).

8. Dispositif suivant la revendication 7, **caractérisé en ce que**
- le générateur HF (4) génère une suite d'oscillations électromagnétiques de fréquence différente ;
- le dispositif de mesure (10) mesure la courbe de la fraction de signal en fonction de la fréquence.

9. Dispositif suivant la revendication 8, **caractérisé en ce que** l'analyseur compare la courbe mesurée de la fraction de signal à une courbe caractéristique préalablement mémorisée de la fraction de signal.

10. Dispositif suivant la revendication 9, **caractérisé en ce que** l'analyseur comporte un écran (11), sur lequel sont affichées conjointement la courbe mesurée de la fraction de signal et la courbe caractéristique mémorisée de la fraction de signal.

11. Dispositif suivant l'une des revendications 7 à 10,
**caractérisé en ce que** la ligne HF présente
- un premier guide d'ondes (5a) qui envoie le signal HF, du générateur HF (4) à la jonction (1), entre un conducteur intérieur (6a) et un conducteur extérieur (7a),
- une première électrode (8a), qui couple le signal HF dans l'une (2a) des deux pièces adjacentes sur l'un des côtés de la jonction (1) et est en liaison de conduction électrique avec le conducteur extérieur (7a) du premier guide d'ondes (5a),
- un second guide d'ondes (5b) qui envoie le signal HF, de la jonction (1) au dispositif de mesure (10), entre un conducteur intérieur (6b) et un conducteur extérieur (7b),
- une seconde électrode (8b), qui découple le signal HF de l'autre pièce (2b) sur le côté opposé de la jonction (1) et est en liaison de conduction électrique avec le conducteur extérieur (7b) du second guide d'ondes (5b),
- un conducteur de raccordement (9), qui met en liaison de conduction électrique le conducteur intérieur (6a) du premier guide d'ondes (5a) et le conducteur intérieur (6b) du second guide d'ondes (5b), le conducteur de raccordement (9) passant sur la jonction.

12. Dispositif suivant la revendication 11, **caractérisé en ce que** la ligne HF est un câble coaxial, dont le conducteur intérieur, sous forme de conducteur de raccordement (9), passe sur la jonction (1), et dont le conducteur extérieur (7a, 7b) est coupé dans la zone de la jonction (1).

13. Dispositif suivant l'une des revendications 7 à 10, dans lequel la ligne HF présente un détecteur pour le contrôle de l'étanchéité HF d'une jonction entre deux pièces adjacentes électriquement conductrices, en particulier des parties de revêtement d'un boîtier blindé HF pour le montage d'appareils électroniques, comprenant
- un premier guide d'ondes (5a), qui achemine un signal HF entre un conducteur intérieur (6a) et un conducteur extérieur (7b),
- une première électrode (8a), qui est en liaison de conduction électrique avec le conducteur extérieur (7a) du premier guide d'ondes (5a) et sert au couplage du signal HF dans l'une (2a) des deux pièces adjacentes sur l'un des côtés de la jonction (1),
- un second guide d'ondes (5b) comportant un conducteur intérieur (6b) et un conducteur extérieur (7b) pour le raccordement à un dispositif de mesure (10),
- une seconde électrode (8b), qui est en liaison de conduction électrique avec le conducteur extérieur (7b) du second guide d'ondes (5b) et sert au découplage du signal HF de l'autre pièce (2b) sur l'autre côté de la jonction (1), et
- un conducteur de raccordement (9), qui met en liaison de conduction électrique le conducteur intérieur (6a) du premier guide d'ondes (5a) et le conducteur intérieur (6b) du second guide d'ondes (5b).

14. Dispositif suivant la revendication 13, **caractérisé en ce que** le premier guide d'ondes (5a) et le second guide d'ondes (5b) sont réalisés sous forme de sections d'un câble coaxial, dont le conducteur extérieur (7a, 7b) est coupé dans la zone comprise entre les deux électrodes (8a, 8b) et dont le conducteur intérieur (6a, 6b, 9) est inter-connecté.

15. Dispositif suivant l'une des revendications 13 et 14, **caractérisé en ce que** les deux électrodes (8a, 8b) sont réalisées en forme de plaques.

16. Dispositif suivant la revendication 15, **caractérisé en ce que** les électrodes (8a, 8b) se situent dans un plan et ont leurs extrémités dirigées l'une vers l'autre.

17. Dispositif suivant la revendication 15, **caractérisé en ce que** les électrodes (8a, 8b) sont disposées perpendiculairement entre elles.

18. Dispositif suivant la revendication 15, **caractérisé en ce que** les électrodes (8a, 8b) sont disposées parallèlement entre elles et à distance l'une de l'autre.

19. Dispositif suivant l'une des revendications 13 à 18, **caractérisé par** un support (16) adapté au contour du boîtier (13) et sur le côté intérieur duquel, tourné vers le boîtier (13), sont disposées les deux électrodes (8a, 8b).

20. Dispositif suivant la revendication 19, **caractérisé par** une poignée (17) assemblée avec le support (16) et traversée par les deux guides d'ondes (5a, 5b ; 18a, 18b).

21. Dispositif suivant l'une des revendications 13 à 19, **caractérisé en ce que**
- le générateur HF (4) est raccordé au premier guide d'ondes (5a),
- le dispositif de mesure (10) est raccordé au second guide d'ondes (5b) ; et
- le générateur HF (4) et le dispositif de mesure (10) sont intégrés au détecteur.

22. Dispositif suivant la revendication 21, **caractérisé en ce que** le détecteur comporte l'analyseur pour l'évaluation de la fraction de signal reçue par le dispositif de mesure (10).
